# Europäisches Patentamt

# European Patent Office

# Office européen des brevets

(11) Publication number: **0 205 963**
**B1**

(12) **EUROPEAN PATENT SPECIFICATION**

(45) Date of publication of the patent specification:
**29.06.88**

(51) Int. Cl.⁴: **C 30 B 23/02**

(21) Application number: **86107142.1**

(22) Date of filing: **26.05.86**

(54) **Method and apparatus for molecular beam epitaxial growth.**

(30) Priority: **27.05.85 JP 113736/85**
**19.04.86 JP 91144/86**

(43) Date of publication of application:
**30.12.86 Bulletin 86/52**

(45) Publication of the grant of the patent:
**29.06.88 Bulletin 88/26**

(84) Designated Contracting States:
**DE FR GB**

(56) References cited:
**EP-A-0 122 446**

(73) Proprietor: **NISSIN ELECTRIC COMPANY, LIMITED, No.47, Umezu Takase- cho, Ukyo- ku Kyoto- shi Kyoto (JP)**
Proprietor: **SUMITOMO ELECTRIC INDUSTRIES LIMITED, No. 15, Kitahama 5-chome Higashi- ku, Osaka- shi Osaka 541 (JP)**

(72) Inventor: **Makabe, Osamu c/o Nissin Electric Company, Ltd., No. 47, Takase- cho Umezu Ukyo- ku, Kyoto- shi Kyoto (JP)**
Inventor: **Mori, Hideki c/o Osaka Works, Sumitomo Electric Ind. Ltd. 1-3, Shimaya 1-chome, Konohana- ku Osaka- shi Osaka (JP)**
Inventor: **Okada, Hiroshi c/o Osaka Works, Sumitomo Electric Ind. Ltd. 1-3, Shimaya 1-chome, Konohana- ku Osaka- shi Osaka (JP)**

(74) Representative: **Barz, Peter, Dr., Patentanwälte Dipl.- Ing. G. Dannenberg Dr. P. Weinhold, Dr. D. Gudel Dipl.- Ing. S. Schubert, Dr. P. Barz Siegfriedstrasse 8, D-8000 München 40 (DE)**

## Description

This invention relates to a method and an apparatus for molecular beam epitaxial growth capable of making a high intensity molecular beam compatible with a uniform film thickness, even when the film is grown over a wide area, by adjusting the relation between the positions of a molecular beam source cell and a substrate holder.

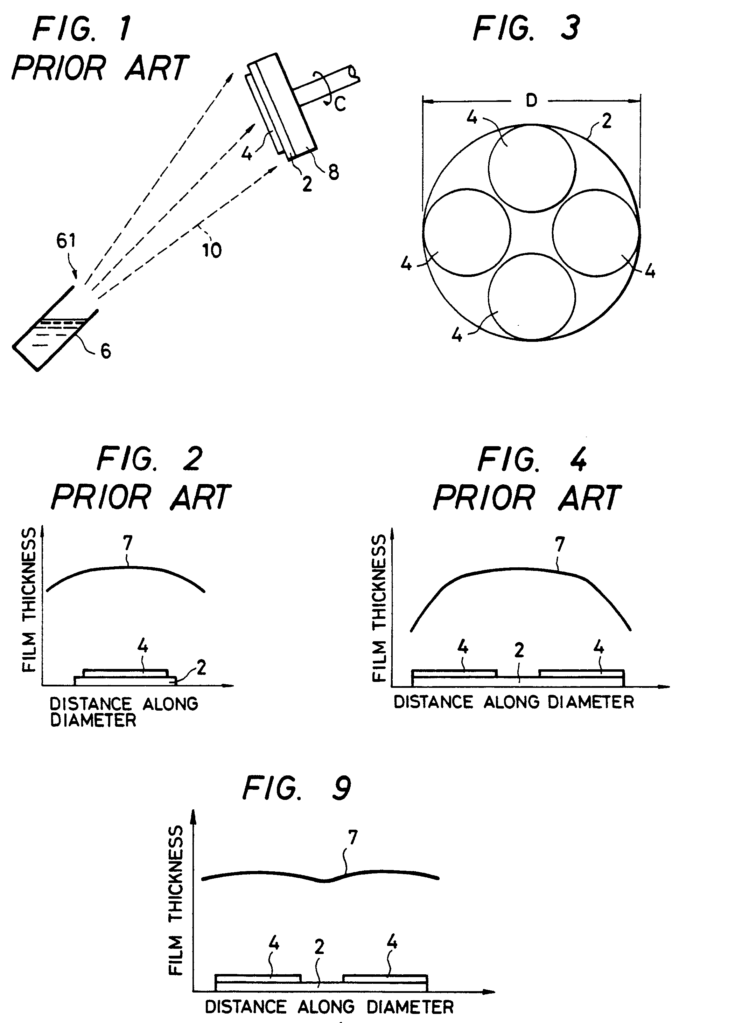

Fig. 1 is a side view showing the relative positions of a conventional molecular beam source cell and a conventional substrate holder. A manipulator 8 is attached to a substrate holder 2 inside a vacuum chamber (not shown). The substrate holder 2 is turned by the manipulator 8, for instance, in the direction of arrow C in Fig. 1. The substrate holder 2 holds a substrate 4. A molecular beam source cell 6 radiates a molecular beam 10 and is so arranged that its opening 61, which defines a molecular beam 10, faces the surface of the substrate 4. Furthermore, it aims the beam 10 at a location close to the center of the substrate 4.

The growth (epitaxial growth) of a film on the substrate 4 is such that, while the substrate holder 2 is being turned by the manipulator 8 to turn the substrate 4, the substrate 4 is heated by a heater (not shown) installed in the manipulator 8. The molecular beam source cell 6 is also heated by a heater (not shown) provided in the molecular beam source cell 6 to make the cell generate the molecular beam 10. The molecular beam 10 is made incident on the substrate 4 and the molecules in the beam accumulate on the substrate 4.

In that case, if the distance between the molecular beam source cell 6 and substrate 4 is set relatively short, the intensity of the molecular beam incident on the substrate 4 will be increased. However, the uniformity of the thickness of the film in growth will be degraded. If the distance between the molecular beam source cell 6 and the substrate is set relatively longer, the uniformity of the film thickness will be improved. However, the intensity of the molecular beam will be decreased in inverse proportion to the square of the distance, thus producing a lower growth rate.

Fig. 2 shows an example of film distribution in the direction along the diameter of the substrate 4 when one substrate is attached to the substrate holder 2 for film growth. As the density distribution of the molecular beam 10 radiated from the molecular beam source cell 6 normally conforms to the cosine law ($\cos^n \theta$ law), the distribution 7 of film thickness is also mountain-shaped. It is, however, possible to obtain a relatively good uniformity of film thickness in a relatively narrow area, e.g., an area equivalent to a 25,4 or 50,8 mm (1 or 2 inch) substrate.

If only one piece of substrate 4 is attached to the substrate holder 2 for film growth, productivity is low because only one piece is grown for each growth cycle. On the other hand, there has been proposed a method for simultaneously growing films on a plurality of substrates by enlarging the substrate holder 2 and attaching a plurality of, e.g., four, pieces of substrate 4 to the substrate holder 2 shown in Fig. 3.

However, the distribution 7 of film thickness over such a wide area will assume the form shown in Fig. 4 and the uniformity of film thickness is thus degraded. In this case also, the longer the distance is between the molecular beam source cell 6 and the substrate 4, the greater the uniformity of film thickness becomes. If the distance therebetween is so increased, the intensity of the molecular beam will be greatly decreased and, as described above, the growth rate will, as a result, also be reduced. The problem is that the intensity of a molecular beam and the uniformity of film thickness are incompatible in the conventional method, such as, where growth is attempted over a large area for the growth of a plurality of substrates.

On the other hand, another proposed idea is such that each of a plurality of substrates 4 be rotated on its own axis and all of them are also revolved in common about a common axis in order to improve the uniformity of film thickness. In that case, however, another problem arises that the mechanism of the manipulator become extremely complicated.

An object of the present invention is to make the high intensity of a molecular beam and the uniformity of film thickness compatible when films are grown in a large area without using a special manipulator.

A method for growth of epitaxy by means of a molecular beam in accordance with the present invention includes the step of attaching more than one substrate to a substrate holder installed in an evacuated chamber. The opening of a molecular beam source cell for irradiating a molecular beam is positioned opposite to the plane of the substrate attached to the substrate holder. The substrate holder is then turned while a film is grown on the substrate by making the molecular beam from the molecular beam source cell incident on the substrate so that the molecules of the beam accumulate on the substrate. The following parameters are defined: a diameter D of the substrate holder, a distance x between a point where the centerline of the molecular beam source cell intersects the plane of the substrate surface and the center of rotation of the substrate holder, and a distance y between the opening of the molecular beam source cell and the plane of the substrate surface on the centerline of the molecular beam source cell. According to the invention, the film is grown under the conditions of $0.4D \leqq x \leqq 0.7D$ (that is, near or slightly outside the radius) and $0.7D \leqq y \leqq 1.6D$.

An apparatus for growth of epitaxy by means of a molecular beam in accordance with the present invention comprises a substrate holder installed in a vacuum chamber, the substrate holder being capable of holding more than one substrate. A manipulator turns the substrate holder. A molecular beam source cell irradiates the molecular beam. An opening of the molecular beam source cell is positioned opposite to a plane of the substrate surface attached to the substrate holder. The following parameters are defined: a diameter D of the substrate holder, a distance x between a point where the centerline of the molecular beam source cell intersects the plane of the substrate surface and the center of rotation of the substrate holder, and a distance y between the opening of the molecular beam source cell and the plane of the substrate surface on the centerline of the molecular beam source cell. According to the invention, the distance x is set within a range of $0.4D \leq x \leq 0.7D$ and the distance y is set within a range of $0.7D \leq y \leq 1.6D$.

Fig. 1 is a side view showing the positional relation between a conventional molecular beam source cell and a substrate holder.

Figs. 2 and 4 are schematic diagrams showing examples of the distribution of film thickness in the diametric direction of a substrate holder obtained through a conventional method.

Fig. 3 is a plan view showing an example of four substrates attached to the substrate holder.

Figs. 5 and 6 are side views illustrating the positional relation between a molecular beam source cell and a substrate holder according to the present invention.

Fig. 7 shows an example wherein the uniformity of film thickness changes when a distance y is changed with a distance x as a parameter.

Fig. 8 shows an example wherein the intensity of a molecular beam changes when the distance y is changedwith the distance x as a parameter.

Fig. 9 is a schematic diagram showing an example of the distribution of film thickness in the diametric direction of the substrate holder obtained according to the present invention.

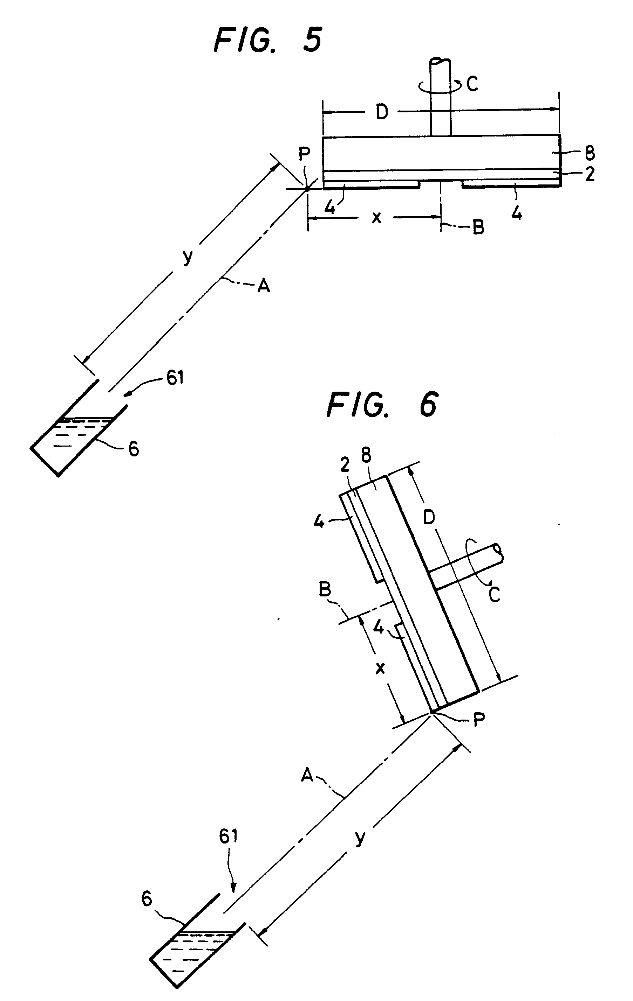

Figs. 5 and 6 are side views illustrating the relation between the positions of the molecular beam source cell and the substrate holder according to the present invention. A substrate holder 2 is attached to a manipulator 8 in a vacuum chamber (not shown) The substrate holder 2 is turned by the manipulator 8 in the direction of arrow C, for instance. A plurality of substrates 4, according to this example, are attached to the periphery of the substrate holder 2 at locations an equal distance apart from its center (see Fig. 6). A molecular beam source cell 6 radiates a molecular beam (not shown) and is so arranged relative to the manipulator that its opening 61 is placed opposite to a plane to which the surface of the above substrate belong. A centerline A of the beam is approximately perpendicular to the center of a surface defined by the opening 61.

In that case, the surface of the substrate holder 2, and therefore the substrates also, may be variously oriented, e.g., downwardly as shown in Fig. 5, diagonally as shown in Fig. 6, laterally (illustration omitted) or any other direction as long as they can satisfy the specified positional relation with the opening 61 of the molecular beam source cell 6.

The molecular beam source cell 6 is so arranged as to aim at a location substantially offset from the center of the substrate holder 2 and near its circumference. First the following parameters are defined. In other words, the diameter D of the substrate holder 2; a distance x between a point P where the centerline A of the molecular beam source cell 6 crosses the plane to which the surfaces of the substrates belong and the rotational center B of the substrate holder 2, and a distance y from the opening 61 of the molecular beam source cell 6 to intersection of the centerline A of the molecular beam source cell 6 with the plane to which the surface of the substrates belong. The distance x is set within a range of $0.4D \leq x \leq 0.7D$, whereas the distance y is set within a range of $0.7D \leq y \leq 1.6D$. Note that, as illustrated in Fig. 5, the point P may lie outside the radius of the substrate holder 2 and the substrates. Films are grown under these conditions and the reason for this will be described later. Because the thickness of the substrate 4 on the substrate holder 2 is so small as to be ignorable in comparison with the distance y (e.g., normally on the order of 0,1 mm), it practically makes no difference to regard the distance y as equivalent to the distance between the opening 61 of the molecular beam source cell 6 and the plane of the surface of the substrate holder 2.

The (epitaxial) growth of the film relative to each substrate 4, in specific terms, comprises the steps of turning the substrate as a whole by turning the substrate holder 2 using the manipulator 8, heating each substrate 4 by means of the same heating means (not shown) as a conventional one, simultaneously heating the molecular beam source cell 6 to make a molecular beam radiate so that its molecular particles are incident on each substrate and accumulated there.

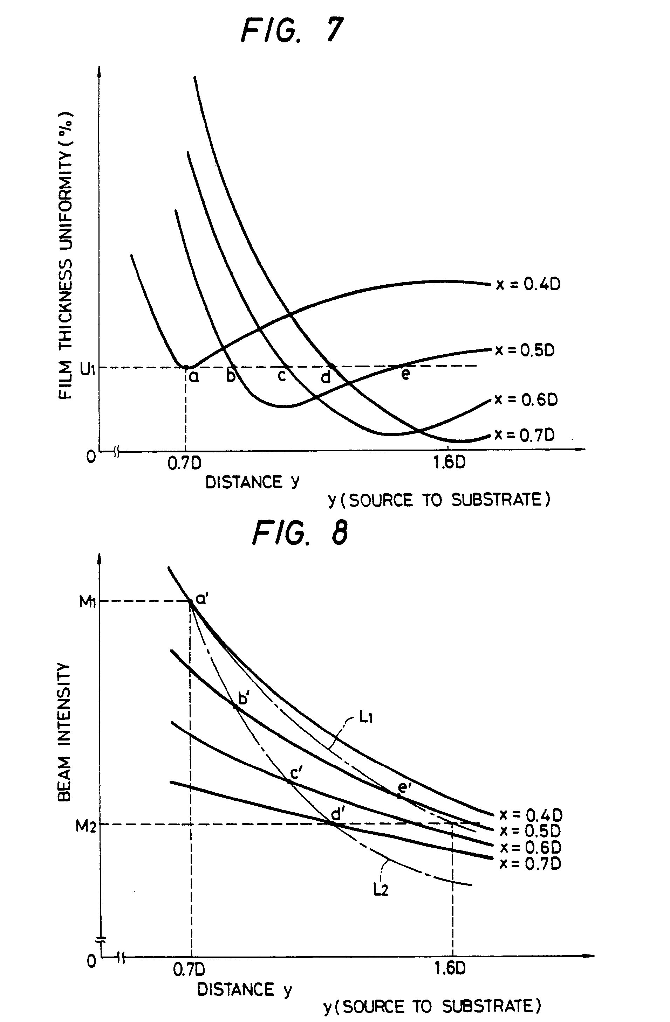

The reasons for setting the distances x and y within the above ranges will be row described. Fig. 7 shows examples in which the uniformity of film thickness changes as the distance y is changed with the distance x as a parameter. The film thickness uniformity has been calculated by obtaining the distribution of film thicknesses by integrating the intensity of a molecular beam at each point along the direction of the diameter of the substrate holder 2 when it is turned. The uniformity would be variations from the normalized integral. In Fig. 7, the uniformity of film thickness is improved as it is located close to the horizontal axis. The value $U_1$ shows an upper limit of the film thickness uniformity practically allowable for an apparatus of this type and, for instance, a variation of several percentage points is generally selected. Obviously, there is an area where the preferred uniformity of film thickness is obtained within the range of x ≤ 0.4D and y ≤ 0.7D.

More specifically, the uniformity of film thickness better than that of the value $U_1$ can be obtained in the following cases. When x = 0.4D, the distance y is a value corresponding to a location close to the point a in Fig. 7. When x = 0.5D, it is within a range of values of y corresponding to the points b to e. When x = 0.6D, it is above a value corresponding to the point c. And, when x = 0.7D, it is above a value corresponding to the point d.

Fig. 8 shows examples in which the intensity of the molecular beam tends to change when the distance y is changed with the distance x as a parameter associated with the solid lines. The intensity of the molecular beam in this case has been calculated as the mean value of the intensities of the molecular beam at each point on the substrate holder 2 obtained through the above calculation. In Fig. 8, obviously the intensity of the molecular beam becomes greater as the plotted point departs from the horizontal axis. An area enclosed by two broken lines $L_1$ and $L_2$ in Fig. 8 shows a range of distances x and y allowable in view of the uniformity of film thickness. These curves $L_1$ and $L_2$ correspond to a continuous plot of points a'- e' which corresponding to the points a-e in Fig. 3. Consequently, a value $M_1$ corresponding to the point a' is an upper limit for the intensity of the molecular beam to assume in consideration of the allowable uniformity of film thickness. On the other hand, if other conditions which reduce the intensity of the molecular beam are selected, the molecular beam radiated from the molecular beam source cell 6 will not be fully utilized and these conditions are thus detrimental to economical operation. Accordingly, the lower limit value $M_2$ of the allowable intensity of the molecular beam is normally selected as about $M_2 = M_1/3$ in this kind of apparatus.

The area satisfying the standard of good uniformity of film thickness and the relatively strong intensity of molecular beam is located in an area which is enclosed by the broken lines $L_1$ and $L_2$ and above the lower limit value $M_2$. The lower limit value $M_2$ introduces the conditions x ≤ 0.7D and y ≤ 1.6D. The collective conditions associated with Figs. 7 and 8 are 0.4D ≤ x ≤ 0.7D and 0.7D ≤ y ≤ 1.6D. These conditions are easily quantifiable but not as precise as the requirement that x and y fall within the area enclosed by lines $L_1$, $L_2$ and $M_2$ in Fig. 8.

Fig. 9 shows an example of the distribution of film thickness in the diametric direction of the substrate holder 2 obtained under the above conditions of 0.4D ≤ x ≤ 0.7D and 0.7D ≤ y ≤ 1.6D. Under the above conditions, the crest of a peak is located in the neighbourhood of the center of each substrate 4 although unevenness in thickness is still slightly observable. The improved uniformity of film thickness is obtained in an area wider than what is available through the conventional method (see Fig. 4 for comparison). Moreover, the intensity of the molecular beam obtainable is relatively greater because it is unnecessary to increase the distance between the molecular beam source cell 6 and the substrate 4. It is noted that the irradiation of multiple substrates 4 is particularly advantageous since the central minimum of the film thickness curve occurs where there is no substrate.

It has thus been confirmed by calculations that the intensity of molecular beam and the uniformity of film thickness are compatible even when films are grown in a wide area, provided that the distances x and y are limited to the above-described ranges.

According to the above-described apparatus, a plurality of substrates 4 can be attached to the substrate holder 2 and simultaneously grown, whereby productivity can also be increased. Needless to say, the improved uniformity of film thickness is available without turning each substrate on its axis but only commonly rotating it around with the other substrates, i.e., only turning the substrate holder 2 as shown in Fig. 5 or 6, so that the construction of the manipulator is not very complicated. Moreover, the distance between the molecular beam source cell 6 and the substrate 4 is reduced and yet the improved uniformity of film thickness is still obtainable. Consequently, a large size vacuum chamber (growth chamber) is unnecessary.

Instead of simultaneous growth of films on a plurality of substrates, a large diameter (e.g., 152.4 mm (6 inches)) substrate may be attached to the substrate holder 2 for the growth of a film and the relatively strong intensity of the molecular beam and the better uniformity of film thickness are, needless to say, available in the same way.

According to the present invention, the intensity of a molecular beam and the uniformity of film thickness are made compatible even when films are grown in a wide area and the relatively greater intensity of the molecular beam and the better uniformity of film thickness can be obtained. Accordingly, it becomes possible to grow films on a plurality of substrates or to grow a film on a large diameter substrate. According to the present invention, moreover, the use of the special manipulator is unnecessary and a vacuum container for the growth of films remains compact.

## Claims

1. A method of molecular beam epitaxial growth, comprising the steps of:

attaching at least one substrate to a substrate holder inside an evacuated chamber, said at least one substrate extending to a diameter D of said holder concentric about a rotation axis perpendicular to a substrate plane containing a surface of said substrate;

rotating said holder about said rotation axis, irradiating a molecular beam onto said at least one substrate from an opening of a molecular beam source cell positioned opposite said substrate plane, thereby growing a film on said substrate by an accumulation of particles in said beam, a distance x being a distance between a point where centerline of source cell intersects said substrate plane and said rotation axis within said substrate plane, a distance y being a distance along said centerline of source cell between said opening of said source cell and said substrate plane,

wherein
$0.4D \leqq x \leqq 0.7D$
and
$0.7D \leqq y \leqq 1.6D$.

2. A growth method as in Claim 1, wherein said attaching step comprises attaching at least two substrates to said substrate holder within an area defined by said diameter D.

3. A growth method as in Claim 1 or 2, where x is approximately equal to 0.4D and y is approximately equal to 0.7D.

4. An apparatus for molecular beam epitaxial growth, comprising:

a substrate holder installed in a vacuum chamber, the substrate holder being capable of holding at least one substrate within a diameter D about a rotation axis;

a manipulator for rotating the substrate holder about said rotation axis; and

a molecular beam source cell for irradiating a molecular beam, an opening of the molecular beam source cell being positioned opposite to a substrate plane to which a surface of the substrate attached to the substrate holder belongs, a distance x being a distance between the point where said centerline of source cell intersects said substrate plane and said rotation axis within said substrate plane, and a distance y being a distance along said centerline of source cell between said opening of said source cell and said substrate plane

wherein
$0.4D \leqq x \leqq 0.7D$
and
$0.7D \leqq y \leqq 1.6D$.

5. A growth apparatus as in Claim 4, wherein said substrate holder is capable of holding more than one substrate within an area defined by said diameter D.

6. A growth apparatus as in claim 4 or 5, where x is approximately equal to 0.4D and y is approximately equal to 0.7D.

## Patentansprüche

1. Verfahren für epitaxiales Aufwachsen mit Molekularstrahlen, umfassend die Schritte:

Befestigen mindestens eines Substrats an einem Substrathalter im Inneren einer evakuierten Kammer, wobei sich das mindestens eine Substrat bis zu einem Durchmesser D des Halters konzentrisch um eine Rotationsachse senkrecht zu einer Substratebene, in welcher eine Oberfläche des Substrates liegt, erstreckt;

Drehen des Halters um die Rotationsachse;

Strahlen eines Molekularstrahles auf das mindestens eine Substrat aus einer Öffnung einer Molekularstrahlen-Quellenzelle, die gegenüber der Substratebene angeordnet ist, wodurch auf dem Substrat durch Akkumulation von Teilchen in dem Strahl ein Film aufwächst, wobei ein Abstand x der Abstand zwischen dem Punkt, an dem die Mittellinie der Quellenzelle die Substratebene schneidet, und der Rotationsachse in der Substratebene ist, ein Abstand y der Abstand entlang der Mittellinie der Quellenzelle zwischen der Öffnung der Quellenzelle und der Substratebene ist,

wobei
$0,4D \leqq x \leqq 0,7D$ und $0,7D \leqq y \leqq 1,6D$.

2. Aufwachsverfahren nach Anspruch 1, worin der Befestigungsschritt das Befestigen von mindestens zwei Substraten an dem Substrathalter innerhalb einer von dem Durchmesser D definierten Fläche umfaßt.

3. Aufwachsverfahren nach Anspruch 1 oder 2, worin x annähernd gleich ist 0,4D und y annähernd gleich ist 0,7D.

4. Vorrichtung für das epitaxiale Aufwachsen mit Molekularstrahlen, umfassend:

einen in einer Vakuumkammer angeordneten Substrathalter, der zum Halten mindestens eines Substrats innerhalb eines Durchmessers D um eine Rotationsachse befähigt ist;

einen Manipulator zum Drehen des Substrathalters um die Rotationsachse; und eine Molekularstrahlen-Quellenzelle zum Ausstrahlen eines Molekularstrahles, wobei eine Öffnung der Molekularstrahlen-Quellenzelle gegenüber einer Substratebene angeordnet ist, in der eine Ebene des an dem Substrathalter befestigten Substrates liegt, wobei ein Abstand x der Abstand zwischen dem Punkt, an dem die Mittellinie der Quellenzelle die Substratebene schneidet, und der Rotationsachse in der Substratebene ist und ein Abstand y der Abstand entlang der Mittellinie der Quellenzelle zwischen der Öffnung der Quellenzelle und der Substratebene ist,

wobei
$0,4D \leqq x \leqq 0,7D$ und $0,7D \leqq y \leqq 1,6D$.

5. Aufwachsvorrichtung nach Anspruch 4, worin der Substrathalter zum Halten von mehr als einem Substrat innerhalb der durch den Durchmesser D definierten Fläche befähigt ist.

6. Aufwachsvorrichtung nach Anspruch 4 oder 5, worin x annähernd gleich 0,4D und y annähernd gleich 0,7D ist.

## Revendications

1. Procédé de croissance épitaxiale par faisceau moléculaire, comprenant les étapes suivantes :

la fixation d'au moins un substrat sur un support de substrat à l'intérieur d'une chambre évacuée, le substrat au moins étant disposé jusqu'a un emplacement correspondant à un diamètre D du support concentriquement à l'axe de rotation qui est perpendiculaire au plan du substrat qui contient une surface du substrat, l'entraînement en rotation du support autour de l'axe de rotation, la projection d'un faisceau moléculaire sur un substrat au moins, par l'ouverture d'une cellule formant une source d'un faisceau moléculaire, placée en face du plan du substrat, si bien qu'un film est formé par croissance sur le substrat par accumulation de particules du faisceau, une distance x étant comprise entre un point auquel l'axe central de la cellule formant la source recoupe le plan du substrat et l'axe de rotation dans le plan du substrat, une distance y étant comprise, le long de l'axe central de la cellule formant la source, entre l'ouverture de cette cellule et le plan du substrat, ces distances étant telles que

$0,4D \leq x \leq 0,7D$
et
$0,7D \leq y \leq 1,6D$.

2. Procédé de croissance selon la revendication 1, dans lequel l'étape de fixation comporte la fixation d'au moins deux substrats au support, dans une zone délimitée par le diametre D.

3. Procédé de croissance selon l'une des revendications 1 et 2, dans lequel x est approximativement égal à 0,4D et y est approximativement égal à 0,7D.

4. Appareil de croissance épitaxiale par faisceau moléculaire, comprenant

un support de substrat placé dans une chambre sous vide, le support pouvant porter au moins un substrat à l'intérieur d'une zone de diamétre D autour de l'axe de rotation,

un manipulateur destiné à faire tourner le support de substrat autour de l'axe de rotation, et une cellule formant une source de faisceau moléculaire, destinée à projeter un faisceau moléculaire, une ouverture de la cellule formant la source du faisceau moléculaire étant placée en face d'un plan du substrat auquel une surface du substrat fixée au support appartient, une distance x étant comprise entre le point auquel l'axe central de la cellule formant la source recoupe le plan du substrat et l'axe de rotation, dans le plan du substrat, et une distance y étant une distance mesurée le long de l'axe central de la cellule formant la source entre l'ouverture de cette cellule et le plan du substrat, ces distances étant telles

que
$0,4D \leq x \leq 0,7D$
et
$0,7D \leq y \leq 1,6D$.

5. Appareil de croissance selon la revendication 4, dans lequel le support est capable de porter plus d'un substrat dans une zone délimitée par le diamètre D.

6. Appareil de croissance selon l'une des revendications 4 et 5, dans lequel x est approximativement égal à 0,4D et y est approximativement égal à 0,7D.

FIG. 1
PRIOR ART

FIG. 3

FIG. 2
PRIOR ART

FIG. 4
PRIOR ART

FIG. 9

1

# FIG. 5

# FIG. 6

0 205 963

## FIG. 7

FILM THICKNESS UNIFORMITY (‰)

U1

a    b    c    d    e

x = 0.4D
x = 0.5D
x = 0.6D
x = 0.7D

O        0.7D                    1.6D
         DISTANCE y
              y (SOURCE TO SUBSTRATE)

## FIG. 8

BEAM INTENSITY

M1    a'

b'
         L1
c'
d'
M2
         L2

e'

x = 0.4D
x = 0.5D
x = 0.6D
x = 0.7D

O        0.7D                    1.6D
         DISTANCE y
              y (SOURCE TO SUBSTRATE)